# EUROPEAN PATENT APPLICATION

(11) **EP 4 583 387 A1**
(43) Date of publication of application: **09.07.2025**
(21) Application number: 24150296.2
(22) Date of filing: 04.01.2024
(51) Int. Cl.: H02M 1/32, H02M 3/335

(54) **POWER SUPPLY SYSTEM AND METHOD OF HANDLING FAULTS IN NON-EARTHED APPARATUS**

(71) Applicant: Axis AB, 223 69 Lund (SE)
(72) Inventor: Ericsson, Andreas, 223 69 Lund (SE)
(74) Representative: AWA Sweden AB

(57) **Abstract**

The present disclosure relates to a power supply system with built-in fault detection comprising: a transformer comprising a primary side and a secondary side, wherein the primary side and the secondary side are galvanically isolated and wherein an input voltage is supplied to the primary side of the transformer; one or more switching elements connected to the primary side of the transformer; a controller configured to control switching of the one or more switching elements to control an output voltage on the secondary side of the transformer; an isolation capacitor connected between the secondary side of the transformer and the primary side of the transformer; fault circuitry connected to the isolation capacitor and configured to detect a switching pattern propagated through a short circuit between the primary side and secondary side of the transformer and further propagated through the isolation capacitor. The disclosure further relates to an electrical apparatus comprising the power supply system and to a method of handling faults in a non-earthed electrical apparatus.

## Description

The present disclosure relates to a power supply system with built-in fault detection. The disclosure further relates to a method of handling faults in a non-earthed apparatus.

### Background

Power over Ethernet (PoE) and regulatory safety standards require electrical isolation between the signals in the ethernet cable and all accessible metal parts of a product. In an electrical device, which has an internal power supply system, the internal power supply system often comprises a flyback topology. A flyback topology is a type of switching power supply circuit for converting one voltage level to another using a transformer, switching elements, a feedback loop and a controller to control the flow of current through a primary side winding of the transformer. When the switch element is turned on, current is passed through the primary side winding of the transformer and energy from the primary side is transferred over to the secondary side winding. The voltage across the secondary side winding is determined by the turns ratio of the transformer, which allows for voltage transformation.

In this type of internal power supply system there is a potential for high voltage spikes, which need to be carefully managed to prevent damage to components and risks of exposing users to high voltages. For example, when the primary side winding of the transformer is switched off, a voltage spike may occur on the primary side. In some electronic devices, in which the load and possible users on the secondary side of the transformer are only allowed to operate on relatively low voltages, peak voltages may cause pain or injury to a user. For example, according to the safety standard IEC 62368, a peak voltage greater than 50 V can be considered to be of a level that could cause pain or injury.

Safety standards require that a product is safe even though a component fails somewhere in the product. If the transformer fails in such a manner that the peak voltage is transferred to the chassis of the electrical device through the secondary side, the chassis will be subjected to the peak voltage and will not be safe to touch anymore. This type of fault is not simple to detect in electrical devices having a transformer-based internal power supply system. There is therefore a risk that the internal power supply system continues its operation in such a scenario and exposes a user to the peak voltage.

Solutions to the problem exist. A common and straightforward solution is to add protective earth to the chassis of the electrical device. This, however, adds costs and complexity to the device as well as the installation. Another solution is to cover the chassis with plastic or another non-conductive material. This may, however, introduce other inconveniences or challenges, such as reduced heat dissipation capabilities and general appearance and robustness of product. This solution may not be possible if the electrical device has external connections.

### Summary

The present disclosure relates to a power supply system with built-in fault detection that does not rely on the electrical device being equipped with protective earth.

The present disclosure relates to, according to a first embodiment, a power supply system with built-in fault detection comprising:
a transformer comprising a primary side and a secondary side, wherein the primary side and the secondary side are galvanically isolated and wherein an input voltage is supplied to the primary side of the transformer;
one or more switching elements connected to the primary side of the transformer;
a controller configured to control switching of the one or more switching elements to control an output voltage on the secondary side of the transformer;
an isolation capacitor connected between the secondary side of the transformer and the primary side of the transformer; and
fault circuitry connected to the isolation capacitor and configured to detect a switching pattern propagated through a short circuit between the primary side and secondary side of the transformer and further propagated through the isolation capacitor.

One advantage of a transformer-based power supply system, such as a flyback converter, is its ability to provide galvanic isolation between the primary side and secondary side of the transformer. In practice this means that the electrical device that the power supply system is part of can have two isolated parts. If the part of the device that uses the output voltage operates on a voltage level that is of a level that does not cause pain or injury to a user, a certain risk of faults in the secondary side of the power supply system may, generally, be manageable.

However, if, for example, the transformer fails in such a manner that the low side of the primary winding of the transformer is shorted to the low side of the secondary winding, which may be connected to the chassis of the device, the user may be directly exposed to a peak voltage, i.e. a voltage that can be considerably higher, for example, 100 V or more, from the primary side of the transformer. Since the primary side and the secondary side are isolated, it is not possible to detect, at the primary or the secondary side, that there is a short to the secondary side and that the energy transfer therefore needs to be immediately stopped.

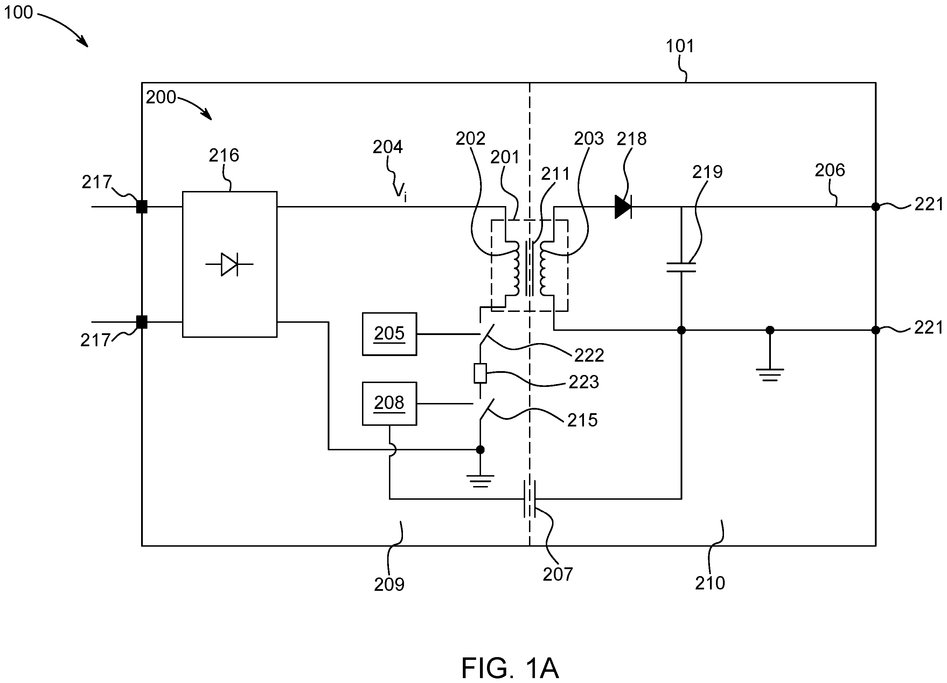

The presently disclosed power supply system comprises an isolation capacitor connected between the secondary side of the transformer and the primary side of the transformer. Isolation capacitors are commonly used for, for example, blocking DC and allowing AC, which may be useful in, for example, certain audio and telecommunication applications and to reduce electromagnetic interference. The inventor has realized that by connecting the secondary side of the transformer to the primary side of the power supply system by means of an isolation capacitor, and using fault circuitry on the primary side of the power supply system to detect a switching pattern propagated through a short circuit between the primary side and secondary side of the transformer and further propagated through the isolation capacitor back to the primary side, an efficient and secure way of detecting and stopping the power supply system from continuing its operation can be obtained. Fig. 1A shows an example of one embodiment of the power supply system with built-in fault detection. In particular it can be noted that the isolation capacitor is connected from the secondary side of the transformer to the fault circuitry on the primary side of the power supply system.

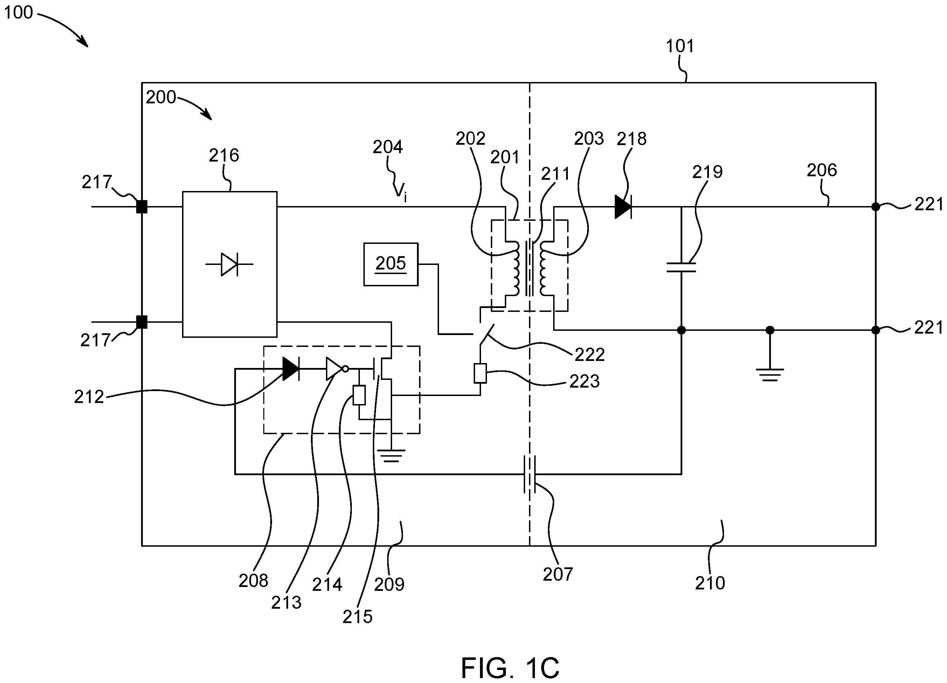

The isolation capacitor may act like a communication element in the sense that it may transfer a switching pattern over the isolation barrier from the secondary side to the primary side. On the primary side a diode can be used to rectify the propagated signal. An additional switch for switching off the current in the primary winding of the transformer may be used to disable switching of the one or more switching elements upon detection of a short circuit between the primary side and secondary side when a fault is detected. This may be implemented, for example, as shown in fig. 1C, using a pull-down or pull-up resistor. For some controllers of switched mode power supplies there is a high/low input pin to control the operation of the power supply that can be used for the same purpose.

The presently disclosed power supply system with built-in fault detection offers an efficient and non-obtrusive solution compared to the existing solutions. The solution eliminates the need to add protective earth to the chassis of the electrical device or cover the chassis with an electrically non-conductive material.

The present disclosure further relates to a method of handling faults in a non-earthed electrical apparatus, the method comprising the steps of:
providing a non-earthed electrical apparatus comprising a power supply system comprising:
   - a transformer comprising a primary side and a secondary side, wherein the primary side and the secondary side are galvanically isolated and wherein an input voltage is supplied to the primary side of the transformer;
   - one or more switching elements connected to the primary side of the transformer;
   - an isolation capacitor connected between the secondary side of the transformer and the primary side of the transformer;
operating the transformer by controlling switching of the one or more switching elements, thereby controlling an output voltage on the secondary side of the transformer;
detecting, on a primary side of the isolation capacitor, a switching pattern propagated through a short circuit between the primary side and secondary side of the transformer and further propagated through the isolation capacitor.

A person skilled in the art will recognize that the presently disclosed method of handling faults in a non-earthed electrical apparatus may be performed using any embodiment of the presently disclosed power supply system, and/or any embodiment of the presently disclosed electrical apparatus comprising the power supply system, and vice versa.

### Brief description of drawings

Various embodiments are described hereinafter with reference to the drawings. The drawings are examples of embodiments and are intended to illustrate some of the features of the presently disclosed power supply system with built-in fault detection.
Figs. 1A-C show examples of embodiments of the power supply system with built-in fault detection.
Fig. 2 shows an example of an electrical apparatus comprising the power supply system.
Fig. 3 shows an example of a flow chart of the presently disclosed method of handling faults in a non-earthed electrical apparatus.

### Detailed description

The present disclosure relates to a power supply system with built-in fault detection. The power supply system comprises a transformer comprising a primary side and a secondary side, wherein the primary side and the secondary side are galvanically isolated. The power supply may further comprise one or more switching elements connected to the primary side of the transformer and a controller configured to control switching of the one or more switching elements to control an output voltage on the secondary side of the transformer. As would, generally, be known by a person skilled in the art, the controller will typically need a feedback loop for adjusting the output voltage. The power supply system may further comprise an isolation capacitor connected, directly or indirectly, from the secondary side of the transformer to the primary side of the transformer, and fault circuitry connected to the isolation capacitor and configured to detect a switching pattern propagated through a short circuit between the primary side and secondary side of the transformer and further propagated through the isolation capacitor. Generally, the primary side and the secondary side of the transformer may refer to two isolated sides of the power supply system, i.e. not only to parts of the transformer itself. In this regard the fault circuitry is thus part of the primary side of the power supply system. The isolation capacitor being "connected between the secondary side of the transformer and the primary side of the transformer" does not necessarily mean that the isolation capacitor is directly connected to the primary side of the transformer. As indicated above, the isolation capacitor is connected to the fault circuitry, which in turn may control the transformer. The fault circuitry may be a separate unit or integrated into the controller. In particular, upon detection of a fault, the controller may stop operation of the transformer, by, directly or indirectly, disabling switching of the one or more switching elements. The power supply system may comprise additional isolation capacitors used for other purposes than detecting faults.

Fig. 1A shows a non-limiting example of one embodiment of the power supply system 200 with built-in fault detection. As can be seen an input voltage 204 is supplied to the primary side of the transformer 201. The input voltage 204 may be seen as the voltage to the transformer 201, preferably a DC voltage that is switched on and off by opening and closing switching element 222.

The electrical apparatus may receive an input voltage for the apparatus 100. The electrical apparatus 100 may have input voltage terminals, for example, in the form of a powered device interface towards a corresponding power sourcing equipment interface. More specifically, the interface may be a Power over Ethernet (PoE) interface. The power source may, accordingly, be a power sourcing equipment, such as a PoE midspan or a network switch with PoE capabilities. The power supply system may be configured to communicate with PoE power sourcing equipment, for example, by detecting the PoE power sourcing equipment and perform power negotiation etc. A person skilled in the art would, generally, be familiar with the implementation of such functions. While the power source may provide a DC voltage, it may still be useful to rectify the input voltage to the electrical apparatus since the input DC voltage may have reversible polarity. In the examples of fig. 1A-C, input rectification circuitry 216 rectifies the input voltage to the electrical apparatus 100. The presently disclosed power supply system 200 may or may not comprise the rectification circuitry. The rectification circuitry 216 may comprise a passive diode rectifier bridge or an active rectifier bridge, such as an active rectifier bridge based on FET transistors. The controller 205, or additional circuitry, may be configured to detect and communicate with a PoE PSE. The power supply system may further comprise output rectification circuitry on the secondary side. A person skilled in the art would be familiar with various implementations of such rectification circuitry. The "input voltage supplied to the primary side of the transformer" may refer to the voltage directly applied to the transformer but may alternatively refer to an input voltage applied indirectly to the primary side of the transformer through, for example, a rectification circuitry in case there is such rectification circuitry.

The power supply system may be an isolated power supply system wherein the transformer comprises primary and secondary windings separated by a non-electrically conductive isolation material, wherein the non-electrically conductive isolation material constitutes an isolation barrier. If the power supply system is part of an electrical apparatus, it is common to design the power supply system and/or the electrical apparatus such that the high-voltage side cannot come in contact with the chassis or any accessible conductive parts. This can be done by, for example, barriers, insulating materials and/or gaps. The presently disclosed power supply system and/or the electrical apparatus may be divided into a high-voltage side and a low-voltage side. The input voltage may be a voltage in the range of 37-57 V. The output voltage may be a voltage in the range of 3.3-24 V. This is under operation without faults, i.e. without voltage spikes included. These voltage levels may be useful in an application involving a PoE midspan or a network switch with PoE capabilities providing the input power to the electrical device. The load may be, for example, power-consuming parts of a surveillance camera or a surveillance camera system.

In one embodiment of the presently disclosed power supply system with built-in fault detection, the power supply system is a power supply system for a PoE-powered electrical apparatus. The power supply system may therefore comprise a controller, or additional circuitry, configured to communicate with a PoE PSE. Such an embodiment may comprise rectification circuitry. Preferably, the power supply system is adapted to handle an input voltage in the range of 37-57 V.

The concept of a high-voltage side and a low-voltage side is illustrated (high-voltage side 209, low-voltage side 210) in figs. 1A-1C. It can be noted that the high-voltage side 209 and the low-voltage side 210 have their own grounds or reference levels, which may be referred to as a high-voltage side ground and a low-voltage side ground, respectively. Both the transformer 201 and the isolation capacitor 207 preferably comprise galvanic isolation between the two sides. In one embodiment of the presently disclosed power supply system and/or the electrical apparatus, primary components or circuitry connected to the primary side of the transformer are isolated from secondary components or circuitry connected to the secondary side of the transformer.

As explained, there is a potential for high voltage spikes on the primary side of the power supply system. When the primary side winding of the transformer is switched off, a voltage spike may occur. If, for example, the primary side of the transformer 201 comprises at least one primary winding and the secondary side of the transformer 201 comprises at least one secondary winding, and there is a short circuit between a low side of the primary winding and a low side of the secondary winding, there may be a voltage peak on the secondary side, more particularly on the low side of the secondary winding. Such a point may be connected to the chassis 101 to provide a common ground or reference level for the secondary side. The short circuit between the isolated primary and secondary sides of the transformer can be caused by a number of factors, including, for example, insulation failure, physical damage and manufacturing defects. If, for example, the insulation material is heated more than it can withstand, it may lose its insulating capacity.

The power supply system further comprises an isolation capacitor connected between the secondary side of the transformer and the primary side of the transformer. Isolation capacitors are commonly used for, for example, blocking DC and allowing AC, which may be useful in, for example, certain audio and telecommunication applications and to reduce electromagnetic interference. In the presently disclosed power supply system, the isolation capacitor may transfer a fault signal over its isolation barrier from the secondary side to the primary side. Due to the short circuit between the primary side and secondary side in the transformer, a switching pattern, which originates from the primary side, is also present on the secondary side. The switching pattern is present on the primary side of the transformer under normal operation but transferred to the secondary side if there is a short circuit between the primary side and secondary side of the transformer. The switching pattern, when present on the secondary side of the short circuited transformed, here represents the fault signal. The isolation capacitor transfers a switching pattern in case there is a short circuit between the primary side and secondary side of the transformer. The isolation capacitor, which can be said to bridge the primary side of the transformer and the secondary side of the transformer, forwards the switching pattern to the primary side, enabling the switching pattern to be detected by the fault circuitry. The fault circuitry, which may optionally be part of the controller on the primary side, is configured to detect the switching pattern, which comprises one or more propagated pulses. The power supply system may comprise a current sense element connected to the primary side of the transformer. The current sense element may be connected between the primary side of the transformer and the ground of the primary side. Alternatively, the current sense element may be connected between the negative side (or low side) of the secondary side of the transformer and the ground of the secondary side. The current sense element may comprise, for example, one or more resistors. The controller may be configured to measure the current and/or voltage in/over the current sense element. In the examples of figs. 1A-C there is a current sense element 223 connected between the negative side (or low side) of the primary side winding 202 of the transformer 201 and the ground of the high-voltage side 209. The fault circuitry is configured to detect a difference in potential between a high-voltage side ground and a low-voltage side ground. The difference in potential between the high-voltage side ground and the low-voltage side ground when observing the switching pattern serves as an indication that there is a short circuit between the primary side and secondary side in the transformer.

Fig. 1A shows an example of an embodiment of the power supply system 200 with built-in fault detection. In this example the fault circuitry 208, which is connected to the isolation capacitor 207, is configured to detect the propagated switching pattern. In this example the fault circuitry 208 controls a fault switching element 215. The fault switching element 215 may in an embodiment be implemented as a generalized on/off switch element, as indicated in fig 1A. The fault switching element 215, is closed in normal operation. In a situation where the fault circuitry 208 detects the fault signal, in the form of the propagated switching pattern via the isolation capacitor 207, the fault circuitry 208 opens the fault switching element 215 to disconnect the current through the primary side winding 202 of the transformer 201.

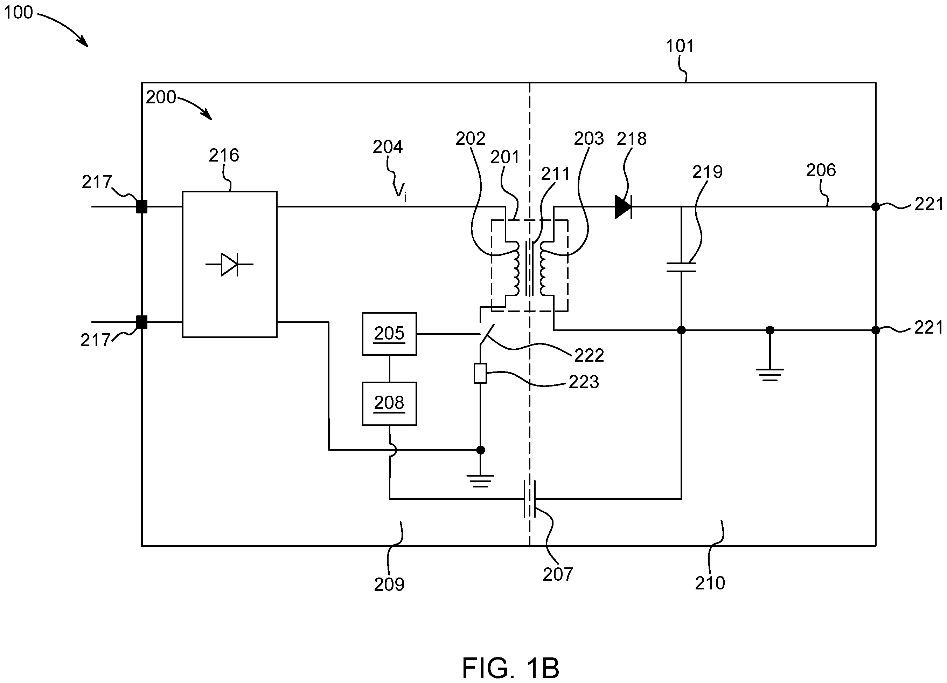

Fig. 1B shows a further example of an embodiment of the power supply system 200 with built-in fault detection. In this example the fault circuitry 208, which is connected to the isolation capacitor 207, is configured to detect the propagated switching pattern. In this example the fault circuitry 208 can disconnect the current through the primary side winding 202 of the transformer 201 indirectly through the controller 205. This can be done in several ways. For some controllers there is an on/off pin to control the operation of the power supply system. The fault circuitry 208 can provide an enable signal that controls such a pin on the controller 205, resulting in that the controller switches off the operation of the power supply system, for instance by controlling the switching element 222 such that it is disconnected/opened when a fault is detected. It is also possible to integrate the fault circuitry 208 into the controller 205, also resulting in that the controller switches off the operation of the power supply system, for instance by controlling the switching element 222 such that it is disconnected/open when a fault is detected.

The controller 205 may thus have several functions. Besides controlling switching of the one or more switching elements to control an output voltage on the secondary side of the transformer in the normal operation, it may disable the transformer from transferring energy from the primary side to the secondary side upon detection of a short circuit between the primary side and secondary side.

The fault circuitry 208 may be further configured to disable the transformer from transferring energy from the primary side to the secondary side upon detection of a short circuit between the primary side and secondary side. This can be done, for example, by disabling switching of the one or more switching elements upon detection of a short circuit between the primary side and secondary side. The fault circuitry may be configured or implemented such that a pulse of a certain magnitude is detected and/or used to turn off the operation of the transformer. According to a specific example, the fault circuitry may comprise a diode connected to the isolation capacitor and a pull-up or pull-down resistor connected to the diode and connected to a fault switching element, for example a control transistor, to disable switching of the one or more switching elements upon detection of a short circuit between the primary side and secondary side. Such a solution may optionally comprise an inverter between the diode and the fault switching element. As would be understood by a person skilled in the art, the fault switching element may be implemented using any suitable type of switch. As mentioned above, for some controllers of switched mode power supplies there is a high/low input pin to control the operation of the power supply. The fault circuitry may be configured to provide a signal that switches off the operation of the transformer. The fault circuitry may thus be configured to control an input to the controller that disables the transformer from transferring energy from the primary side to the secondary side. The signal from the isolation capacitor may be rectified and/or amplified to provide a suitable control signal for turning off the operation of the power supply when there is a pulse having a peak voltage greater than a predefined voltage threshold. The fault circuitry may alternatively, or in combination, comprise pulse detection circuitry. The pulse detection circuitry may be further configured to disable operation of the transformer when a first pulse in the switching pattern is detected.

Fig. 1C includes a specific example of fault circuitry 208. In this example the isolation capacitor 207 is serially connected to a fault circuitry diode 212, which is further serially connected to a fault circuitry inverter 213, which controls a fault switching element 215, here implemented as a control transistor (with a pull-down resistor 214 connected to ground), that can disconnect the current through the primary side winding 202 of the transformer 201. As described above, alternative embodiments of the fault circuitry are possible.

The power supply system may be, but is not strictly limited to, a flyback transformer power supply system or a forward transformer power supply system, and/or a push pull converter.

Fig. 1A shows an example of an embodiment of the power supply system 200 with built-in fault detection in an electrical apparatus 100, which has a chassis 101. The power supply system 200 has a powered device interface 217, in this specific example in the form of PoE connectors. The input voltage to the electrical apparatus 100 is rectified by means of input rectification circuitry 216. The output voltage of the input rectification circuitry 216 is the input voltage 204 to the transformer 201 of the power supply system 200. The power supply system 200 comprises a transformer 201 having a primary side winding 202 and a secondary side winding 203 and a switching element 222. A controller 205 is configured to control switching of the switching element 222 to control an output voltage on the secondary side of the transformer 201. The power supply system 200 further comprises output rectification in the form of an output rectification diode 218, and an output smoothening capacitor 219. An output voltage 206 may be supplied to a current consuming component or system, for example by means of a voltage supply connection 221. An isolation capacitor 207 is connected between the secondary side of the transformer and the primary side of the transformer, more specifically from a low side of the secondary winding 203 to the fault circuitry 208. The fault circuitry can open a fault switching element 215 if a fault is detected. Fig. 1B is identical to fig. 1A except that in fig. 1B fault circuitry 208 is connected to the controller 205, which may disable the transformer 201 from transferring energy from the primary side to the secondary side upon detection of a fault.

The present disclosure further relates to an electrical apparatus comprising any embodiment of the presently disclosed power supply system.

The electrical apparatus may have a high-voltage side and a low-voltage side that are galvanically isolated, wherein the electrical apparatus comprises a power supply system comprising: a transformer comprising a primary side and a secondary side, wherein the primary side and the secondary side are galvanically isolated and wherein an input voltage is supplied to the primary side of the transformer; one or more switching elements connected to the primary side of the transformer; a controller configured to control switching of the one or more switching elements to control an output voltage on the secondary side of the transformer; an isolation capacitor connected between the high-voltage side and the low-voltage side; fault circuitry connected to the isolation capacitor and configured to detect a switching pattern propagated through a short circuit between the primary side and secondary side of the transformer and further propagated through the isolation capacitor.

The electrical apparatus may comprise a chassis, such as an electrically conductive chassis. Typically, the chassis is a metal housing that the device is encased in. In some devices the chassis may serve as the internal earth or reference of the device. The chassis of the presently disclosed electrical apparatus may be a non-earthed chassis. The secondary side of the transformer may therefore be, directly or indirectly, connected to the chassis. The electrical apparatus may have a high-voltage side and a low-voltage side that are galvanically isolated. In such a device it is common that the primary side of the transformer is galvanically isolated from the chassis under operation without faults. If there, however, is a short circuit in the transformer, the previously mentioned voltage peaks may propagate to the low-voltage side of the electrical apparatus.

The electrical apparatus may comprise a powered device interface, such as a Power over Ethernet (PoE) interface providing an input voltage to the electrical apparatus. A power sourcing equipment, such as a midspan or a network switch with PoE capabilities, enables an existing network to support PoE. The power sourcing equipment, which adds power to the ethernet cable, may be placed between a network switch and powered devices. The input voltage to the presently disclosed electrical apparatus may be a voltage from a PoE midspan or a network switch with PoE capabilities.

The electrical apparatus may be any electrical apparatus that can benefit from the presently disclosed power supply system. An electrical apparatus will typically include one or more components that use electrical current. Such components may be the load of the power supply system. As an example, a surveillance camera or a surveillance camera system comprises parts that need to be powered by a local power supply system. The camera itself may need to be controlled and there may be additional circuitry for obtaining, storing, processing, communicating images from the camera etc. As would be understood by a person skilled in the art, the electrical apparatus may comprise a number of entities, including, for example, one or more processing units, one or more memories, which may be used for storing instructions that can be executed by any of the processing units, internal and external network interfaces, input and/or output ports, modules for sending and receiving data wirelessly, communication interface that allows software and/or data to be transferred between the system and external devices.

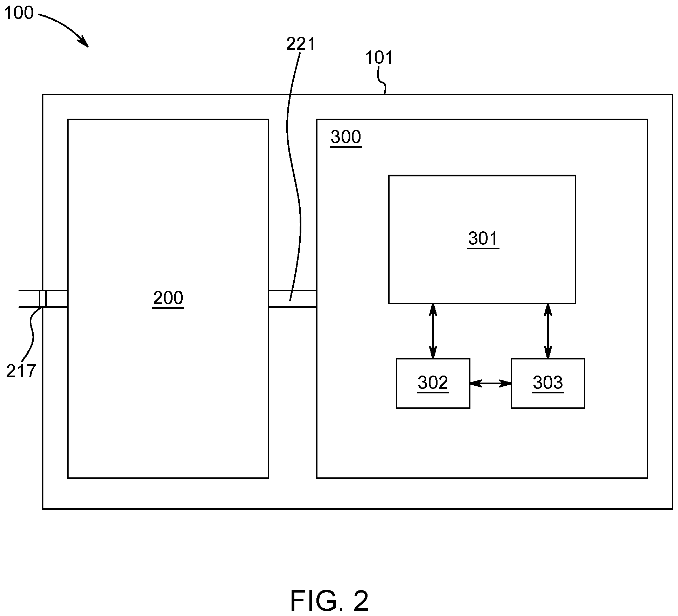

Fig. 2 shows an example of an electrical apparatus 100 comprising a power supply system 200 and a powered device subsystem 300. The power supply system 200 receives an input voltage from a powered device interface 217 and delivers an output voltage to the powered device subsystem 300 through a voltage supply connection 221. The electrical apparatus 100, for instance a camera, has a chassis 101. The powered device subsystem 300 comprises a functional electrical power-consuming entity 301, for instance an optical part and/or a motorized part of a camera, processing circuitry 302 and further peripheral components 303.

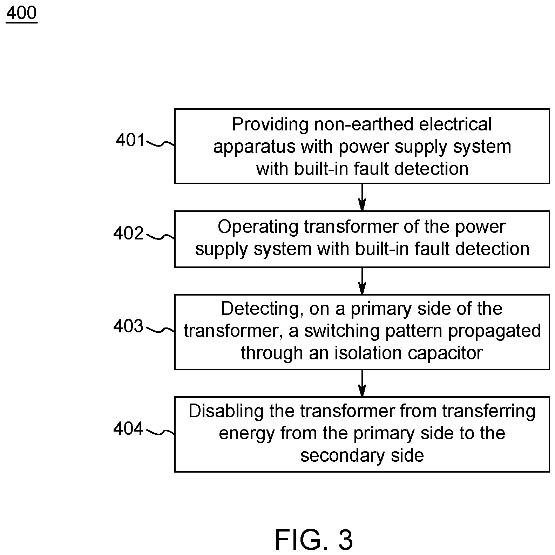

Fig. 3 shows an example of a flow chart of the presently disclosed method 400 of handling faults in a non-earthed electrical apparatus. The method in fig. 3 comprises the steps of providing a non-earthed electrical apparatus comprising a power supply system with built-in fault detection 401, comprising: a transformer comprising a primary side and a secondary side, wherein the primary side and the secondary side are galvanically isolated and wherein an input voltage is supplied to the primary side of the transformer; one or more switching elements connected to the primary side of the transformer; an isolation capacitor connected between the secondary side of the transformer and the primary side of the transformer; operating the transformer of the power supply system with built-in fault detection 402, by controlling switching of the one or more switching elements, thereby controlling an output voltage on the secondary side of the transformer and detecting, on a primary side of the transformer, a switching pattern propagated through an isolation capacitor 403, wherein the switching pattern is propagated through a short circuit between the primary side and secondary side of the transformer and further propagated through the isolation capacitor The method may be carried out by any processing circuitry.

The method may further comprise the step of disabling the transformer from transferring energy from the primary side to the secondary side 404 upon detection of a short circuit between the primary side and secondary side. This can be achieved using any embodiment of the presently disclosed power supply system and/or electrical apparatus. This step is optional.

### List of elements in figures

100 - electrical apparatus
101 - chassis
200 - power supply system
201 - transformer
202 - primary side winding
203 - secondary side winding
204 - input voltage
205 - controller
206 - output voltage
207 - isolation capacitor
208 - fault circuitry
209 - high-voltage side
210 - low-voltage side
211 - non-electrically conductive isolation material
212 - fault circuitry diode
213 - fault circuitry inverter
214 - fault circuitry pull resistor
215 - fault switching element
216 - input rectification circuitry
217 - powered device interface
218 - output rectification diode
219 - output smoothening capacitor
221 - voltage supply connection
222 - switching element
223 - current sense element
300 - powered device subsystem
301 - functional electrical power-consuming entity
302 - processing circuitry
303 - further peripheral components
400 - method of handling faults in a non-earthed electrical apparatus
401 - providing non-earthed electrical apparatus with power supply system
402 - operating transformer of the power supply system
403 - detecting switching pattern propagated through an isolation capacitor
404 - disabling the transformer from transferring energy

## Claims

1. A power supply system (200) with built-in fault detection comprising:
a transformer (201) comprising a primary side and a secondary side, wherein the primary side and the secondary side are galvanically isolated and wherein an input voltage (204) is supplied to the primary side of the transformer (201);
one or more switching elements (222) connected to the primary side of the transformer (201);
a controller (205) configured to control switching of the one or more switching elements (222) to control an output voltage (206) on the secondary side of the transformer (201);
an isolation capacitor (207) connected between the secondary side of the transformer (201) and the primary side of the transformer (201);
fault circuitry (208) connected to the isolation capacitor (207) and configured to detect a switching pattern propagated through a short circuit between the primary side and secondary side of the transformer (201) and further propagated through the isolation capacitor (207).

2. The power supply system (200) according to claim 1, wherein the power supply system (200) is an isolated power supply system wherein the transformer (201) comprises primary and secondary windings (202; 203) separated by a non-electrically conductive isolation material (211), wherein the non-electrically conductive isolation material (211) constitutes an isolation barrier.

3. The power supply system (200) according to any one of the preceding claims, wherein primary components or circuitry connected to the primary side of the transformer (201) are isolated from secondary components or circuitry connected to the secondary side of the transformer (201).

4. The power supply system (200) according to any one of the preceding claims, wherein the isolation capacitor (207) bridges the primary side of the transformer (201) and the secondary side of the transformer (201).

5. The power supply system (200) according to any one of the preceding claims, wherein the fault circuitry (208) is configured to detect one or more propagated pulses in the switching pattern.

6. The power supply system (200) according to any one of the preceding claims, comprising a current sense element (223), wherein the fault circuitry (208) is configured to detect a difference in potential between a high-voltage side ground and a low-voltage side ground over the current sense element (223).

7. The power supply system (200) according to any one of the preceding claims, wherein the fault circuitry (208) is further configured to disable the transformer (201) from transferring energy from the primary side to the secondary side upon detection of a short circuit between the primary side and secondary side.

8. The power supply system (200) according to claim 7, wherein the fault circuitry (208) is configured to disable switching of the one or more switching elements (222) upon detection of a short circuit between the primary side and secondary side.

9. The power supply system (200) according to any one of the preceding claims, wherein the fault circuitry (208) is configured to control an input to the controller (205) to disable the transformer (201) from transferring energy from the primary side to the secondary side.

10. The power supply system (200) according to any one of the preceding claims, wherein the primary side of the transformer (201) comprises at least one primary winding (202) and the secondary side of the transformer (201) comprises at least one secondary winding (203), and wherein the short circuit is a short circuit between a low side of the primary winding (202) and a low side of the secondary winding (203).

11. The power supply system (200) according to any one of the preceding claims, wherein the power supply system (200) is a flyback transformer power supply system or a forward transformer power supply system.

12. An electrical apparatus (100) comprising the power supply system (200) according to any one of the preceding claims.

13. The electrical apparatus (100) according to claim 12, comprising a chassis (101), such as a non-earthed chassis (101), wherein the secondary side of the transformer (201) is, directly or indirectly, connected to the chassis (101).

14. The electrical apparatus (100) according to claim 13, wherein the primary side of the transformer (201) is galvanically isolated from the chassis (101) under operation without faults.

15. A method (400) of handling faults in a non-earthed electrical apparatus (100), the method comprising the steps of:
providing (401) a non-earthed electrical apparatus (100) comprising a power supply system (200) comprising:
- a transformer (201) comprising a primary side and a secondary side, wherein the primary side and the secondary side are galvanically isolated and wherein an input voltage (204) is supplied to the primary side of the transformer (201);
- one or more switching elements (222) connected to the primary side of the transformer (201);
- an isolation capacitor (207) connected between the secondary side of the transformer (201) and the primary side of the transformer (201);
operating (402) the transformer (201) by controlling switching of the one or more switching elements (222), thereby controlling an output voltage (206) on the secondary side of the transformer (201);
detecting (403), on a primary side of the isolation capacitor (207), a switching pattern propagated through a short circuit between the primary side and secondary side of the transformer (201) and further propagated through the isolation capacitor (207).

## Amended claims

### Amended claims in accordance with Rule 137(2) EPC.

1. A power supply system (200) with built-in fault detection comprising:
a transformer (201) comprising a primary side and a secondary side, wherein the primary side and the secondary side are galvanically isolated and wherein an input voltage (204) is supplied to the primary side of the transformer (201);
one or more switching elements (222) connected to the primary side of the transformer (201);
a controller (205) configured to control switching of the one or more switching elements (222) to control an output voltage (206) on the secondary side of the transformer (201);
fault circuitry (208) configured to detect a switching pattern propagated through a short circuit between the primary side and secondary side of the transformer (201),
**characterized in that**:
the power supply system (200) comprises an isolation capacitor (207) connected between the secondary side of the transformer (201) and the primary side of the transformer (201);
the fault circuitry is connected to the isolation capacitor (207) and the switching pattern is further propagated through the isolation capacitor (207);
primary components or circuitry connected to the primary side of the transformer (201) are isolated from secondary components or circuitry connected to the secondary side of the transformer (201); and
the fault circuitry is configured to detect a difference in potential between a high-voltage side ground and a low-voltage side ground.

2. The power supply system (200) according to claim 1, wherein the power supply system (200) is an isolated power supply system wherein the transformer (201) comprises primary and secondary windings (202; 203) separated by a non-electrically conductive isolation material (211), wherein the non-electrically conductive isolation material (211) constitutes an isolation barrier.

3. The power supply system (200) according to any one of the preceding claims, wherein the isolation capacitor (207) bridges the primary side of the transformer (201) and the secondary side of the transformer (201).

4. The power supply system (200) according to any one of the preceding claims, wherein the fault circuitry (208) is configured to detect one or more propagated pulses in the switching pattern.

5. The power supply system (200) according to any one of the preceding claims, comprising a current sense element (223), wherein the fault circuitry (208) is configured to detect a difference in potential between a high-voltage side ground and a low-voltage side ground over the current sense element (223).

6. The power supply system (200) according to any one of the preceding claims, wherein the fault circuitry (208) is further configured to disable the transformer (201) from transferring energy from the primary side to the secondary side upon detection of a short circuit between the primary side and secondary side.

7. The power supply system (200) according to claim 6, wherein the fault circuitry (208) is configured to disable switching of the one or more switching elements (222) upon detection of a short circuit between the primary side and secondary side.

8. The power supply system (200) according to any one of the preceding claims, wherein the fault circuitry (208) is configured to control an input to the controller (205) to disable the transformer (201) from transferring energy from the primary side to the secondary side.

9. The power supply system (200) according to any one of the preceding claims, wherein the primary side of the transformer (201) comprises at least one primary winding (202) and the secondary side of the transformer (201) comprises at least one secondary winding (203), and wherein the short circuit is a short circuit between a low side of the primary winding (202) and a low side of the secondary winding (203).

10. The power supply system (200) according to any one of the preceding claims, wherein the power supply system (200) is a flyback transformer power supply system or a forward transformer power supply system.

11. An electrical apparatus (100) comprising the power supply system (200) according to any one of the preceding claims.

12. The electrical apparatus (100) according to claim 11, comprising a chassis (101), such as a non-earthed chassis (101), wherein the secondary side of the transformer (201) is, directly or indirectly, connected to the chassis (101).

13. The electrical apparatus (100) according to claim 12, wherein the primary side of the transformer (201) is galvanically isolated from the chassis (101) under operation without faults.

14. A method (400) of handling faults in a non-earthed electrical apparatus (100), the method comprising the steps of:
providing (401) a non-earthed electrical apparatus (100) comprising a power supply system (200) comprising:
- a transformer (201) comprising a primary side and a secondary side, wherein the primary side and the secondary side are galvanically isolated and wherein an input voltage (204) is supplied to the primary side of the transformer (201);
- one or more switching elements (222) connected to the primary side of the transformer (201);
- an isolation capacitor (207) connected between the secondary side of the transformer (201) and the primary side of the transformer (201),
wherein primary components or circuitry connected to the primary side of the transformer (201) are isolated from secondary components or circuitry connected to the secondary side of the transformer (201),
operating (402) the transformer (201) by controlling switching of the one or more switching elements (222), thereby controlling an output voltage (206) on the secondary side of the transformer (201);
detecting (403), on a primary side of the isolation capacitor (207), a switching pattern propagated through a short circuit between the primary side and secondary side of the transformer (201) and further propagated through the isolation capacitor (207);
detecting a difference in potential between a high-voltage side ground and a low-voltage side ground.
